# NEW EUROPEAN PATENT SPECIFICATION

(11) **EP 0 100 232 B2**
(45) Date of publication and mention of the opposition decision: **23.03.1994**
(45) Mention of the grant of the patent: 01.03.1989
(21) Application number: 83304301.1
(22) Date of filing: 25.07.1983
(51) Int. Cl.: H01L 23/14, H01L 23/36

(54) **Substrate for semiconductor apparatus**
Substrat für Halbleiterapparat
Substrat pour appareil à semi-conducteurs

(30) Priority: 26.07.1982 JP 131026/82
(43) Date of publication of application: 08.02.1984
(73) Proprietor: SUMITOMO ELECTRIC INDUSTRIES LIMITED, Osaka-shi, Osaka 541 (JP)
(72) Inventor: Osada, Mituo c/o Sumitomo Electric Ind. Ltd., Itami-shi Hyogo (JP); Amano, Yoshinari c/o Sumitomo Electric Ind. Ltd., Itami-shi Hyogo (JP); Ogasa, Nobuo c/o Sumitomo Electric Ind. Ltd., Itami-shi Hyogo (JP); Ohtsuka, Akira c/o Sumitomo Electric Ind. Ltd., Itami-shi Hyogo (JP)
(74) Representative: Warren, Francis Charles

(56) References cited:
- DE-A- 1 141 725
- DE-A- 1 143 588
- DE-A- 2 853 951
- GB-A- 857 569
- US-A- 3 423 203
- Pulvermetallurgie und Sinterwerkstoffe. F. Benesovsky seite 146-156

## Description

This invention relates to an integrated circuit package incorporating a semiconductor chip. An object of the invention is to provide a superior carrier for the semiconductor chip, which is capable of efficiently radiating heat developed from the semiconductor chip and has the inherent characteristic of having a thermal expansion coefficient similar to those of the semiconductor chip and of the material of other apparatus surrounding it.

The substrate material for the semiconductor chip carriers has conventionally employed an Ni alloy consisting of Kovar (29% Ni-17% Co-Fe), 42 alloy; etc. or ceramics, such as alumina, forsterite, etc. since the substrate has hitherto had to have a thermal expansion coeffficient similar to that of the semiconductor chip, and to meet the demand for high heat radiation, various Cu alloys have been used.

However, recent remarkable progress of the semiconductor industry has promoted semiconductor chips of greater size increased amount of heat and the demand for substrate material to meet both the characteristics of thermal expansion coefficient and heat radiation has been on the increase.

Under such conditions, tungsten, molybdenum, beryllia, etc., have been proposed as materials to meet both the above characteristics.

Beryllia, however, is not in fact usable owing to the problem of environmental pollution. Although the thermal expansion coefficient of tungsten or beryllia is well matched with that of semiconductor chip, but has a large difference from that of alumina often used as the enclosure material and also from that of GaAs, the use of which has recently increased, and furthermore the tungsten and molybdenum are inferior to beryllia as regards heat radiation, which greatly restricts the packaging design.

DE-A-2853951 discloses substrates for semiconductors made from a metal such as copper or silver with a high thermal conductivity and a porosity of 5 to 50 volume %, one or both sides of which may be coated with a compact, non-porous layer of a metal such as tungsten, molybdenum or copper.

The inventors, after research to eliminate the above defects of material of conventional substrates used as semiconductor chip carriers and thereby control the thermal expansion coefficient and obtain a substrate material of good heat conductivity.

The present invention consists in an integrated circuit package in accordance with claim 1.

The semiconductor chip carrier substrate has a thermal expansion coefficient similar to those of the semiconductor chip and alumina enclosure material, and is superior in heat conductivity.

Such a substrate, when electrical-insulating properties is required, is subjected at the surface to thin-layer coating of ceramic or organic insulator, thereby being usable instead of conventional ceramic.

In this invention, a Cu content of 5 to 20/wt.% in W and/or Mo is used to render the thermal expansion coefficient of the substrate as similar as possible to those of Si and GaAs and the sintered alumina enclosure material, thereby reducing as much as possible the influence of stresses caused by the mismatch between the thermal expansion coefficients of the substrate and semiconductor chip and enclosure material.

Hence, a proper amount of Cu need only be selected in the above range corresponding to the formation and size of the package.

The substrate of the invention is obtained by containing Cu in W and/or Mo by powder metallurgy, because manufacture by a melting method is difficult owing to the melting point and specific gravity differences of Cu, W and Mo. Among the powder metallurgy methods, sintering and infiltration are preferable.

It is also possible when making the Wand/or Mo skeleton to add thereto an iron group element in an amount of 20 wt.% or less.

A preferable amount of iron group element to be added is below 5 wt.%, but even above that a satisfactory skeleton can be formed with iron group metal contents up to 20 wt.%.

The addition of an amount over 20 wt.%, however, is not preferable because the sintered compact produced does not have the thermal characteristics required for the purposes of the invention.

The amount of iron group element can be the same whether added to both W and Mo or to W or Mo independently.

As can be seen from the above, the substrate used in the package of the invention can meet the steadily increasing demand hereafter for semiconductor chips of large size and high density, and can be used as the substrate for GaAs chips which are being promoted for practical use as well as Si chips.

Preferred embodiments of the invention will be described in the following examples.

### Example 1

Tungsten and a powder mixture of the tungsten and an iron group element were compacted to a size of 100 x 100 x 5 mm respectively, and sintered under an H₂ gas atmosphere at a temperature of 1000 to 1400°C, thereby obtaining an intermediate sintered compactwith porosity of 1 to 5%. Cu was infiltrated into the sintered compact under an H₂ gas atmosphere at a temperature of 1200°C to produce a Cu-W alloy of Cu content of 1 to 40 wt.%.

The Cu-W alloy thus produced was measured for thermal expansion coefficient and thermal conductivity to obtain the results in table 1.

In addition, the thermal expansion coefficients of A1₂0₃, Si and GaAs were entered therein.

The marks ^{*} in Table 1 represents comparison examples outside the scope of claims of the invention.

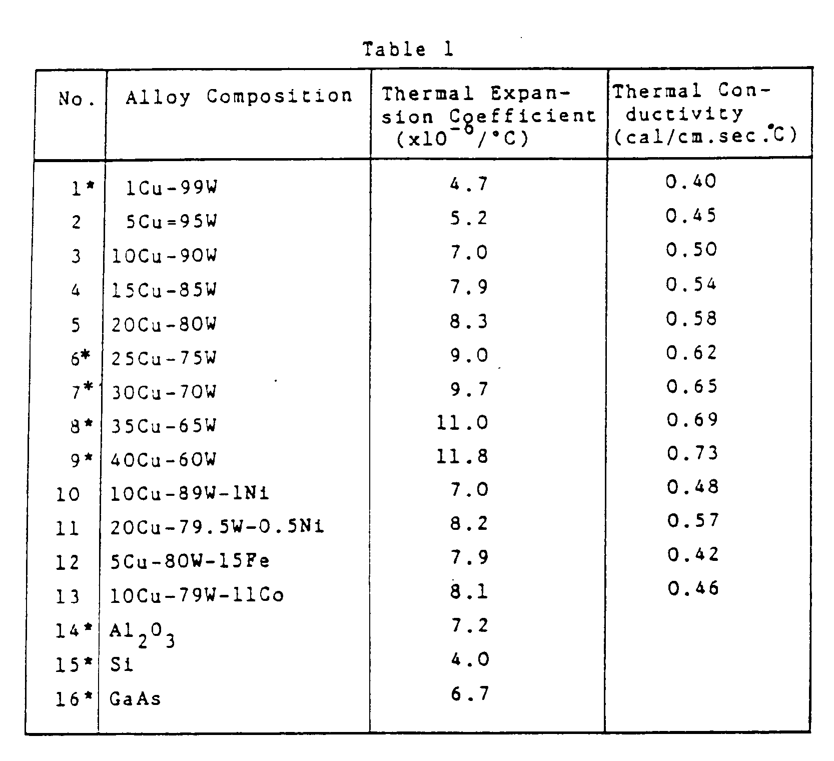

In the above Table 1, an IC package using Cu-W alloy sintered compact (No. 3) of Cu content 10 wt.% as the carrier substrate for an Si chip produced no heat distortion owing to the small difference between the thermal expansion coefficients of the Si chip and enclosure base material of A1₂0₃ during the mounting process, and an extremely good heat radiation as the device could produce an IC of longer life span and high reliability.

### Example 2

Molybdenum and a powder mixture thereof with an iron group element were compacted to a size of 100 x 100 x 5 mm respectively, and then sintered under an H₂ gas atmosphere at a temperature of 1000 to 1400°C, thereby obtaining an intermediate sintered compact with porosity of 1 to 50%.

Copper was infiltrated into the intermediate sintered compact under an H₂ gas atmosphere at a temperature of 1200°C. thereby producing Cu-Mo alloy of copper content of 1 to 50 wt.%.

The Cu-Mo alloy thus produced was measured for its thermal expansion, coefficient and heat conductivity, giving the results in Table 2.

In addition, the marks ^{*} show comparison examples outside the scope of claim of the invention.

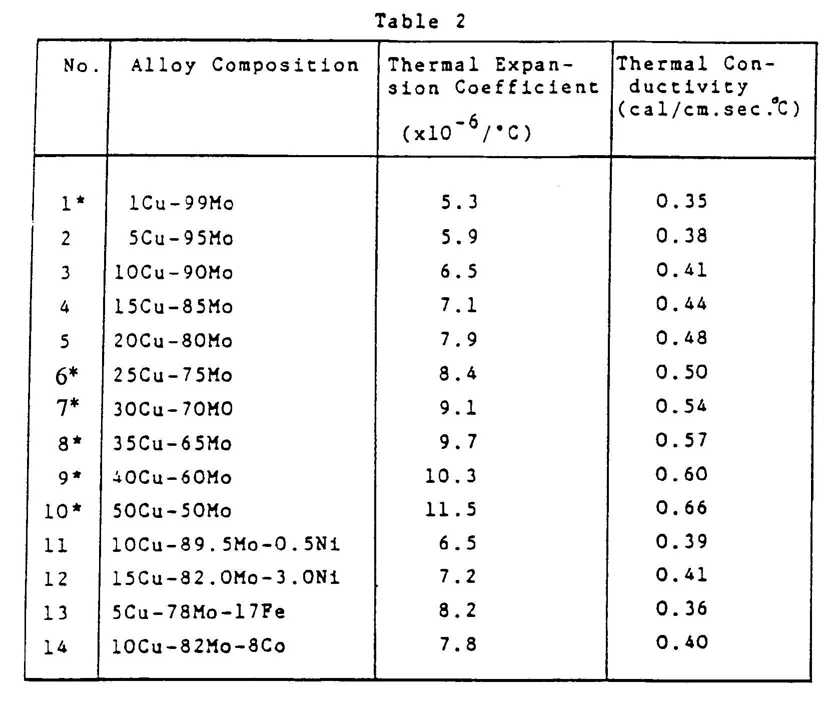

In the above Table 2, an IC package using Cu-Mo alloy sintered compact (No. 4) as the substrate base material for an Si chip produced no heat distortion at all owing to the small difference between the thermal expansion coefficients of the Si chip and enclosure base material of A1₂0₃ during the mounting process, and an extremely good heat radiation as the device could produce an IC of longer life span and a high reliability.

### Example 3

Tungsten, molybdenum powder or tungsten - molybdenum alloy powder and the required amounts of copper powder and iron group powder were mixed as shown in Table 3, and the powder was mixed by an attrition mixer uniformly for three hours, compacted to a size of 30 x 30 x 5 mm under pressure of 1 t/cm², and then sinstered under an H₂ gas atmosphere at a temperature of 1450°C for one hour.

The alloy thus produced was measured for its thermal expansion coefficient and heat conductivity, giving the results in Table 3. In addition, in Table 3, the marks ^{*} show the comparison examples outside the scope of claims of the invention.

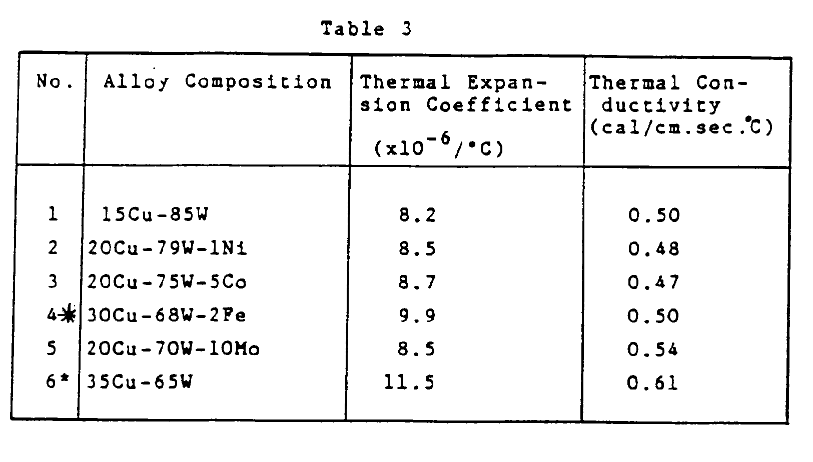

## Claims

1. An integrated circuit package comprising a semiconductor chip mounted on a carrier substrate, the carrier substrate being mounted in an enclosure base of alumina Af 2°3, the substrate having a thermal expansion coefficient similar to those of the chip and of the alumina, characterised in that the substrate is one in which pore portions of a sintered body obtained by pressing and sintering using tungsten or molybdenum powders or a mixture thereof are filled by molten copper so as to form an alloy of tungsten and/or molybdenum with copper either
by a method in which inner pores of the sintered body are filled with molten copper by means of infiltration of 5-20 wt.%, based on the total composition, of copper to a sintered body obtained by pressing and sintering tungsten or molybdenum powders or mixed powders of tungsten and molybdenum or
by a method in which inner pores of the sintered body are filled with molten copper obtained at the same time when 5-20 wt. %, based on the total composition, of copper powders, have been mixed in advance with tungsten or molybdenum powders or mixed powders of tungsten and molybdenum and pressed and sintered.

2. An integrated circuit package according to claim 1 whose substrate has a thin layer coating of a ceramic or organic insulator thereon.

3. An integrated circuit package according to claim 1 or claim 2 wherein the semiconductor chip comprises Si or GaAs.

4. A substrate according to any preceding claim which has a thin-layer coating of a ceramic or organic insulator thereon.

5. A substrate according to any preceding claim with a semiconductor chip thereon, wherein the substrate has a thermal expansion coefficient similar to that of the chip.

6. A substrate according to claim 5 wherein the semniconductor chip comprises Si or GaAs.

7. An integrated circuit package comprising a substrate and semiconductor chip combination according to claim 5 or claim 6 mounted in an enclosure base material having a thermal expansion coefficient similar to those of the substrate and the semiconductor chip.

8. An integrated circuit package according to claim 7 wherein the enclosure base material comprises A1₂0₃.

## Patentansprüche

1. Ein integrierter Schaltkreis, der einen Halbleiterchip umfaßt, der auf ein Tragersubstrat montiert ist, wobei das Trägersubstrat in einem A1₂0₃-Sockel montiert ist und im wesentlichen denselben termischen Ausdehnungskoeffizienten wie der Halbleiterchip und derA1₂0₃-Sockel aufweist, dadurch gekennzeichnet,
daß das Substrat so beschaffen ist, daß darin Porenteile eines gesinterten Körpers, der durch Pressen und Sintern unter Verwendung von Wolfram- oder Molybdänpulver oder einer Mischung daraus erhalten ist, mit geschmolzenem Kupfer gefüllt werden, um eine Legierung aus Wolfram und/oder Molybdäne mit Kupfer zu bilden,
entweder durch ein Verfahren, mit dem innere Poren des gesinterten Körpers mit geschmolzenem Kupfer gefüllt werden, und zwar durch Infiltration von 5 - 20 Gewichtsprozent Kupfer bezogen auf die gesamte Zusammenstellung, wobei die Infiltration in den gesinterten Körper stattfindet, der durch Pressen und Sintern von Wolfram- oder Molybdänpulver oder Pulvermischungen aus Wolfram und Molybdän erhalten ist, oder durch ein Verfahren, bei dem innere Poren des gesinterten Körpers mit geschmolzenem Kupfer gefüllt werden, welches gleichzeitig erhalten wird, während 5 - 20 Gewichtsprozent Kupferpulver, bezogen auf die gesamte Zusammenstellung, vorher in Wolfram- oder Molybdänpulver oder in ein Pulvergemisch aus Wolfram und Molybdän eingemischt und gepreßt und gesintert worden sind.

2. Ein integrierter Schaltkreis nach Anspruch 1, denen Substrat einen dünnlagigen Belag aus Keramik oder organischem Insolator aufweist.

3. Ein integrierter Schaltkreis nach Anspruch 1 oder 2, wobei der Halbleiterchip Silicium (Si) oder GalliumArsenid (GaAs) enthält.

4. Substrat nach einem der Ansprüch 1 bis 3, dadurch gekennzeichnet, daß er einen dünnlagigen Belag aus Keramik oder organischem Isolator besitzt.

5. Substrat nach Ansprüch 1 bis 4 mit einem Halbleiter-Chip darauf, dadurch gekennzeichnet, daß das Substrat einen thermischen Expansionskoefffizienten gleich dem des Chips besitzt.

6. Substrat nach Anspruch 5, dadurch gekennzeichnet, daß der Halbleiter Si oder GaAs enthält.

7. Integrierte Schaltbaueinheit, bestehend aus einer Substrat- und Halbleiter-Chip-Kombination nach Anspruch 5 oder 6, die in eine Basismaterialumhüllung mit einem Wärmeausdehnungskoeffizienten gleich dem des Substrates und dem des Halbleiter-Chips montiert ist.

8. Integrierte Schaltbaueinheit nach Anspruch 7, dadurch gekennzeichnet, daß die Basismaterialumhüllung aus A1₂0₃ besteht.

## Revendications

1. Boîtier de circuit intégré comprenant une puce à semiconducteur montée sur un substrat porteur, le substrat porteur étant monté dans une base de boîtier en oxyde d'aluminium A1₂0₃, le substrat ayant un coefficient de dilatation thermique semblable à ceux de la puce et de l'oxyde d'aluminium, caractérisé en ce que le substrat est un de ceux dans lequel les parties poreuses d'un corps aggloméré obtenu par pressage et par frittage en utilisant des poudres de tungstène ou de molybdène, ou un mélange de celles-ci, sont remplies avec du cuivre fondu, de manière à former un alliage de tungstène et/ou de molybdène avec du cuivre, par :
un procédé selon lequel les pores internes du corps aggloméré sont remplis avec le cuivre par infiltration de 5 à 20% en poids sur la base de la composition totale de cuivre au corps aggloméré obtenu par pressage et par frittage de poudre de tungstène ou de molybdène, ou de poudres de tungstène et de molybdène mélangées, ou bien par
un procédé selon lequel les pores internes du corps aggloméré sont remplis avec du cuivre fondu obtenu en même temps que 5 à 20% en poids sur la base de la composition totale de poudres de cuivre ont été mélangées préalablement avec des poudres de tungstène ou de molybdène ou avec des poudres mélangées de tungstène ou de molybdène, et pressées et frittées.

2. Boîtier de circuit intégré selon la revendication 1, dont le substrat a sur lui un revêtement en fine couche d'un isolant en matière céramique ou organique.

3. Boîtier de circuit intégré selon la revendication 1 ou 2, dans lequel la puce à semiconducteur comprend du Si ou du GaAs.

4. Un substrat selon l'une quelconque des revendications précédentes, qui comporte un revêtement en fine couche d'un isolant en matière céramique ou organique.

5. Un substrat selon l'une quelconque des revendications précédentes, qui supporte une puce à semiconducteur, dans lequel le substrat a un coefficient de dilatation thermique semblable à celui de la puce.

6. Un substrat selon la revendication 5, dans lequel la puce à semiconducteur comprend du silicium Si ou de l'arséniure de gallim GaAs.

7. Un boîtier de circuit intégré comprenant une combinaison de substrat et de puce à semiconducteur selon la revendication 5 ou la revendication 6, montée dans un matériau de base du boîtier ayant un coefficient de dilatation thermique semblable à ceux du substrat et de la puce à semiconducteur.

8. Un boîtier de circuit intégré selon la revendication 7, dans lequel le matériau de base du boîtier comprend de l'alumine AI₂0₃.
